(19) Europäisches Patentamt
European Patent Office
Office européen des brevets

(11) EP 1 872 144 B1

(12) **EUROPÄISCHE PATENTSCHRIFT**

(45) Veröffentlichungstag und Bekanntmachung des Hinweises auf die Patenterteilung:
04.05.2016 Patentblatt 2016/18

(21) Anmeldenummer: 06743066.0

(22) Anmeldetag: 24.05.2006

(51) Int Cl.:
*G01R 27/26* (2006.01)    *H03M 3/00* (2006.01)

(86) Internationale Anmeldenummer:
**PCT/EP2006/004989**

(87) Internationale Veröffentlichungsnummer:
**WO 2006/125639 (30.11.2006 Gazette 2006/48)**

(54) **KAPAZITÄTSMESSSCHALTUNG**

CAPACITY MEASURING CIRCUIT

CIRCUIT DE MESURE DE CAPACITE

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: 25.05.2005 DE 102005024098
17.08.2005 DE 102005038875

(43) Veröffentlichungstag der Anmeldung:
**02.01.2008 Patentblatt 2008/01**

(73) Patentinhaber: **Fraunhofer-Gesellschaft zur Förderung der angewandten Forschung e.V.
80686 München (DE)**

(72) Erfinder:
• **HARTMANN, Marcus
91058 Erlangen (DE)**
• **MÖDL, Stefan
91161 Hilpoltstein (DE)**
• **HAUER, Johann
91058 Erlangen (DE)**

(74) Vertreter: **Zimmermann, Tankred Klaus
Schoppe, Zimmermann, Stöckeler
Zinkler, Schenk & Partner mbB
Patentanwälte
Radlkoferstrasse 2
81373 München (DE)**

(56) Entgegenhaltungen:
WO-A-03/071230        WO-A-2004/090570
WO-A-2006/011975      US-A- 5 659 254
US-A- 6 140 952        US-A1- 2004 008 041
US-B1- 6 300 776       US-B1- 6 452 521

# Beschreibung

Die vorliegende Erfindung befasst sich mit der Messung von Kapazitäten und insbesondere mit einem Konzept zur präzisen Messung einer Kapazität und der Bereitstellung des Messergebnisses als digitaler Bitstrom.

Kapazitive Sensoren werden in der Messtechnik und Sensorik im breiten Umfang eingesetzt. Beispielsweise können Entfernungen zwischen zwei Messpunkten bestimmt werden, wenn die Kapazität zwischen den beiden Messpunkten präzise gemessen wird, so dass bei Kenntnis des theoretischen Zusammenhangs zwischen Kapazität und Entfernung über die gemessene Kapazität auf die Entfernung zwischen den beiden Messpunkten geschlossen werden kann. Allgemein wird die Kapazität zwischen zwei Oberflächen durch die Geometrie der Oberflächen sowie ein die Oberflächen umgebendes Dielektrikum bestimmt. Verändert man die Eigenschaften des Dielektrikums, indem man ein Material mit anderen dielektrischen Eigenschaften in die Nähe der Oberflächen bringt, so ändert sich dabei die Kapazität zwischen den beiden Oberflächen zum Teil erheblich.

Viele technische Anwendungen machen sich dies zu Nutze, indem sie eine Kapazitätsänderung dazu verwenden, das Berühren eines Gegenstands oder einer Oberfläche nachzuweisen. Dies ist beispielsweise bei der Ansteuerung spezieller berührungsempfindlicher Displays der Fall. Insbesondere lässt sich auch die Berührung des Rahmens einer Autoscheibe durch ein menschliches Körperteil mittels kapazitiver Messung nachweisen, wozu beispielsweise die Kapazität zwischen zwei in dem Dichtungsgummi eingearbeiteten Drähten oder die Kapazität zwischen einem einzelnen Draht und dem metallischen Scheibenrahmen bestimmt wird. Dadurch lässt sich ein zuverlässiger Einklemmschutz implementieren, der verhindert, dass ein elektrischer Scheibenhebermotor die Autoscheibe schließt, wenn ein Körperteil die Dichtungsfläche berührt oder sich in deren Nähe befindet, so dass schwere Verletzungen vermieden werden. Die kapazitive Messung hat dabei den großen Vorteil, dass sie gegenüber herkömmlichen Verfahren, die auf einem Anstieg des Motorstroms beim Auftreffen der Scheibe auf ein Hindernis basieren, wesentlich sicherer ist, da für die Funktion des Verfahrens kein mechanischer Kontakt zwischen Scheibe und Körperteil erforderlich ist. Beim mechanischen Kontakt kann unter Umständen bereits eine vergleichsweise geringe Kraft, die eine geringe, unterhalb der Regelschwelle liegende, Stromänderung verursacht, eine Verletzung, beispielsweise einer Kinderhand, hervorrufen. Ein Nachlaufen des Elektromotors kann ebenfalls dazu führen, dass eingeklemmte Körperteile verletzt werden, obwohl ein Einklemmen prinzipiell bereits erkannt ist. Durch die kapazitive Messung werden oben beschriebene Probleme prinzipiell verhindert.

Um eine genaue Messung von geringen Kapazitätsänderungen zu ermöglichen, sind eine Reihe von Messverfahren bekannt.

So werden beispielsweise verstimmbare Oszillatoren (angeregte RCL - Kreise) verwendet, bei denen die Resonanzfrequenz durch eine sich ändernde Kapazität beeinflusst wird. Dabei wird als Messgröße üblicherweise die über einem ohmschen Widerstand R abfallende Spannung bestimmt, die bei festem Widerstand R und fester Induktivität L proportional zur Kapazität ist. Normalerweise muss die gemessene Spannung dann digitalisiert werden, um aus der Proportionalitätsbeziehung die Kapazität zu errechnen.

Des Weiteren sind Ladungsübertragungsverfahren (Chargetransfer) üblich, bei denen eine erste Kapazität in einer ersten Phase aufgeladen und die Ladung in einer zweiten Phase in eine zweite Kapazität übertragen wird. Hierbei kann sowohl die erste wie auch die zweite Kapazität als Messkapazität verwendet werden. Dabei muss die Größe der Messkapazität bekannt sein, um die Kapazität des zu messenden Kondensators bestimmen zu können. Üblicherweise wird als Messgröße die über der Messkapazität abfallende Spannung bestimmt.

Oft werden zur Kapazitätsmessungen auch Brückenschaltungen verwendet, bei denen die zu messende Kapazität durch ein zeitaufwändiges Abgleichverfahren ermittelt wird, in dem üblicherweise eine Diagonalspannung der Brückenschaltung zu Null geregelt wird.

Darüber hinaus können Synchron-Demodulator-Verfahren zur Kapazitätsmessung angewendet werden.

Da zur weiteren Signalverarbeitung die analogen Messsignale typischerweise digitalisiert werden, tritt oftmals das Problem auf, dass der von dem analogen Sensor (beispielsweise einer Kapazität) gelieferte Ausgangsspannungsbereich mit dem dynamischen Eingangsbereich einer nachgeschalteten Analog/Digital-Wandlerstufe nicht übereinstimmt, was zu einer Verringerung der Genauigkeit des digitalen Messergebnisses führt.

Die US- 6,452,521 B1 beschreibt daher ein Konzept, wie der dynamische Bereich eines analogen Messsignals am Ausgang eines Sensors auf den dynamischen Eingangsbereich eines Delta-Sigma-Modulators angepasst (gemapped) werden kann. Um dies zu erreichen, wird ein Mapping-Schaltkreis an den Integrator eines Delta-Sigma-Modulators gekoppelt, um den analogen Eingangsbereich des Integrators an den analogen Ausgangsbereich des Sensors anzupassen. Dabei liefert der Integrator ein integriertes Ausgangssignal an einen Controller, welcher ein digitales Ausgangssignal erzeugt, wobei das digitale Ausgangssignal in einem digitalen Wertebereich liegt, der den möglichen Wertebereich des analogen Eingangssignals repräsentiert.

Bislang verwendete Kapazitätsmessverfahren beruhen auf analogen Schaltungen, deren Messsignal mit aufwändiger analoger Signalverarbeitung bearbeitet oder analog an einen Analog/Digital-Umsetzer übermittelt werden müssen, um eine darauffolgende digitale Weiterverarbeitung zu ermöglichen. Die große Anzahl an elektrischen Bauelementen, die für eine solche Implementierung von Nöten ist, ist dabei zum Einen hinsichtlich der entstehenden Kosten nachteilig. Zum anderen entsteht dadurch ein erhöhter Platzbedarf in der Implementierung, was ebenfalls nachteilig ist, wenn nur wenig Platz zur Verfügung steht wie beispielsweise beim Einbau von Kapazitätsmessschaltungen in ein Fahrzeug.

Bei Überwachungsaufgaben spielt darüber hinaus das Zeitverhalten des Messkreislaufs eine große Rolle. Verstimmbare Oszillatoren beispielsweise müssen sich erst auf eine neue Frequenz einschwingen, bis eine zuverlässige Messung erfolgen kann, wobei die nachfolgende Analog/Digital-Wandlung zusätzliche Zeit benötigt, so dass ein zuverlässiges Messergebnis erst nach langer Messdauer vorliegt.

Um Kapazitäten zu messen sind in der Literatur eine Reihe weiterer unterschiedlicher Ansätze bekannt, beispielsweise zeigt das US-Patent 6300776 einen Delta-Sigma-Modulator zur Messung des Blindwiderstands einer Kapazität, wobei die zu messende Kapazität getaktet und wechselseitig zum Einen mit einer Referenzspannung und zum Anderen mit dem invertierenden Eingang eines Integrators verbunden wird, wobei diese mit einem weiteren Anschluss fest gegen Masse geschalten ist.

Die internationale Patentanmeldung WO03/071230 beschreibt eine Kapazitätsmessschaltung zur Messung zweiter Messkapazitäten, bei der die Differenz der zu messenden Kapazitäten mittels des Delta-Sigma-Modulationsprinzips bestimmt wird, indem die beiden Kapazitäten wechselseitig an Referenzspannungen unterschiedlicher Polarität geschalten werden.

Die internationale Patenanmeldung WO2009/090570 beschreibt, wie ein Eingang eines Analog-Digital-Wandlers mit einem Offset-Signal einer Offset-Einrichtung so beaufschlagt werden kann, dass im zeitlichen Mittel das am Eingang des Analog-Digital-Wandlers anliegende Signal Null ist. Dadurch wird von dem Analog-Digital-Wandler lediglich eine Signaländerung detektiert.

Die Aufgabe der vorliegenden Erfindung besteht darin, eine Kapazitätsmessschaltung zum effizienteren Messen einer Kapazität zu schaffen.

Diese Aufgabe wird durch eine Kapazitätsmessschaltung gemäß Anspruch 1 gelöst.

Der vorliegenden Erfindung liegt die Erkenntnis zugrunde, dass eine Kapazität genau und effizient gemessen werden kann, wenn bei einem Delta-Sigma-Modulator, der einen Operationsverstärker, einen ersten mit einem Eingang des Operationsverstärkers verbindbaren Kondensator und einen zweiten Kondensator in einem Rückkopplungszweig des Operationsverstärkers aufweist, eine Referenzsignalquelle mit dem ersten Kondensator verbindbar ist, wobei der erste oder der zweite Kondensator eine zu messende Kapazität bildet.

Durch die Tatsache, dass nicht, wie üblich, eine Eingangsgröße am Eingang des Delta-Sigma-Modulators gemessen und digitalisiert werden soll, sondern dass statt dessen am Eingang eine definierte Referenzsignalquelle angeschlossen wird und ein Bauteil des Delta-Sigma-Modulators selbst die Messgröße bildet, wird eine äußerst kompakte Schaltung geschaffen, die eine Möglichkeit zur schnellen und zuverlässigen Messung von Kapazitäten schafft.

Mit einer erfindungsgemäßen Kapazitätsmessschaltung kann also mit Hilfe einer kompakten integrierten Schaltung eine Kapazität mit hoher Präzision vermessen werden, wobei nur ein sehr geringer Bauteileaufwand von Nöten ist.

Ein weiterer großer Vorteil der vorliegenden Erfindung besteht darin, dass das Messergebnis unmittelbar in digitaler Form vorliegt, so dass eine zusätzliche Digitalisierung und der damit verbundene zusätzliche Schaltungsaufwand vermieden werden kann.

Ein synchron betriebener Delta-Sigma-Umsetzer kann mit einer hohen Taktfrequenz betrieben werden kann, so dass ein Messergebnis äußerst schnell zur Verfügung steht. Zusätzlich kann durch eine nachgeschaltete Signalverarbeitung der digitale Bitstrom, der von dem Delta-Sigma-Umsetzer unmittelbar geliefert wird, einfach weiter verarbeitet werden, so dass beispielsweise durch Mittelwertbildung die Messgenauigkeit unkompliziert weiter erhöht werden kann.

In einer weiteren beispielhaften Anordnung wird ein Delta-Sigma-Modulator in geschalteter Kapazitätstechnik implementiert. Das heißt, die Ströme, die zur Integration eines Signals notwendig sind, werden zeitdiskret an den Eingang des Integrierers angelegt, wobei die Ströme durch Entladen von Kondensatoren erzeugt werden. Zeitgleich werden die auf dem Kondensator im Eingangszweig befindliche Ladungen und die Balanceladung, welche, abhängig von dem momentanen Zustand des Delta-Sigma-Modulators, positives oder negatives Vorzeichen haben kann, auf die Integrationskapazität eines Integrators übertragen. Die sich am Ausgang des Integrators einstellende analoge Spannung U ist dann proportional zum Verhältnis der Kapazitäten des Eingangskondensators $C_{in}$ zum Rückkoppelkondensator $C_{ruck}$ (U ~ $C_{in}$ / $C_{rück}$).

Die Anzahl der Takte, die bis zu einem Umschalten der Integrationsrichtung nötig ist, bestimmt die Auflösung des digitalisierten Ausgangssignals, so dass die Auflösung vorteilhafterweise durch das Verhältnis der Eingangskapazität zur Rückkoppelkapazität in weiten Grenzen eingestellt werden kann, um eine Quantisierung zu erreichen, die eine wanschgemäße Genauigkeit des Messergebnisses ermöglicht.

Da das Ausleseergebnis von dem Verhältnis der Eingangskapazität zur Rückkopplungskapazität abhängt, kann die zu messende Kapazität sowohl die Kapazität im Eingangszweig als auch die Rückkopplungskapazität sein, wobei vorteilhafterweise diejenige Kapazität als Messgröße verwendet werden kann, für die sich das Ankoppeln des Messsensors aus schaltungstechnischer Sicht leichter realisieren lässt.

In einem weiteren Beispiel wird zusätzlich zur Eingangskapazität eine Offsetkapazität verwendet, die mit dem Eingang des Integrators zeitgleich mit der Eingangskapazität verbindbar ist und die mittels einer Offsetspannung geladen werden kann. Dabei ist die Offsetspannung betragsmäßig der Referenzspannung der Eingangskapazität gleich, jedoch weisen die beiden Spannungen unterschiedliche Vorzeichen auf. Durch die Summierung der Ladungen der beiden Kapazitäten wird es dadurch möglich, von einer zu integrierenden Ladung einen Ladungsoffset abzuziehen, was gleichbedeutend damit ist, von der zu messenden Kapazität einen statischen Anteil abzuziehen. Dies kann besonders dann vorteilhaft sein, wenn die zu messende Kapazität einen statischen und einen dynamischen Anteil hat, wobei der statische Anteil nicht von Interesse ist, so dass er durch das Anbringen einer Offsetkapazität, die in etwa der statischen Kapazität der Messkapazität entspricht, unterdrückt werden kann.

Für das erfindungsgemäße Konzept zum Messen von Kapazitäten hängt die erzielbare Messgenauigkeit hauptsächlich von der stabilen Erzeugung zweier zueinander inverser Referenzspannungen ab und beruht nicht auf der exakten Einhaltung von Parametern passiver Bauelemente, wie z.B. Kapazitäten und Induktivitäten. Zwei komplementäre Spannungen sind mit bekannten Schaltungsprinzipien leicht zur Verfügung zu stellen, wobei die Gleichheit der Absolutbeträge der beiden Spannungen sichergestellt werden kann, woraus sich eine hohe Messgenauigkeit der erfindungsgemäßen Kapazitätsschaltung ergibt, da diese von den weit streuenden Parametern diskreter Bauelemente weitestgehend unabhängig ist.

In einem bevorzugten Ausführungsbeispiel der vorliegenden Erfindung wird ein differenzieller Operationsverstärker verwendet, der vollkommen symmetrisch beschaltet ist. Der differentielle Operationsverstärker weist dabei einen ersten und einen zweiten Rückkopplungszweig mit identischen Rückkopplungskapazitäten auf. Die zu messende Kapazität ist dabei zwischen den invertierenden und den nicht-invertierenden Eingang des differenziellen Operationsverstärkers schaltbar. Die beiden an den differenziellen Ausgängen des differenziellen Operationsverstärkers anliegenden Signale werden zur weiteren Verarbeitung addiert, so dass sich insgesamt eine erhöhte Empfindlichkeit der erfindungsgemäßen Kapazitätsmessschaltung ergibt. Ein weiterer großer Vorteil der differenziellen Beschaltung ist, dass eventuelle Störsignale, die beispielsweise durch Induktion der Kapazitätsschaltung eingeprägt werden, durch den differenziellen Operationsverstärker mit unterschiedlichen Vorzeichen verstärkt werden, so dass die anschließende Addition die störenden Signaleinflüsse unterdrückt. Dies ist in der technischen Anwendung beispielsweise vorteilhaft, wenn die Kapazität durch zwei lange, in der Gummidichtung einer Autotür geführte Drähte erzeugt wird. Diese können als Antenne wirken und somit unerwünschte zusätzliche Stromflüsse hervorrufen, die dann jedoch von der differenziellen Ausführung der vorliegenden Erfindung kompensiert werden.

Bevorzugte Ausführungsbeispiele der vorliegenden Erfindung werden nachfolgend Bezug nehmend auf die beiliegenden Zeichnungen näher erläutert. Es zeigen:

Fig. 1    Beispiel einer Kapazitätsmessschaltung:

Fig. 2a   Beispiel für eine alternative Schaltungsmöglichkeiten einer Messkapazität;

Fig. 2b   Timingdiagramm zur Schaltung der Messkapazität von Fig. 2a;

Fig. 3    Beispiel einer Kapazitätsmessschaltung mit zusätzlicher Möglichkeit des Offsetabzugs;

Fig. 4    Beispiel einer Kapazitätsmessschaltung mit zu messender Kapazität im Rückkoppelzweig;

Fig. 5    Beispiel einer Kapazitätsmessschaltung mit zu messender Kapazität im Eingangzweig;

Fig. 6    Ausführungsbeispiel für eine Kapazitätsmessschaltung in differenzieller Struktur;

Fig. 7a   Schaltbild eines Delta-Sigma-Modulators;

Fig. 7b   Signalverläufe des Delta-Sigma-Modulators von Fig. 7a;

Fig. 8    Prinzipschaltbild zur Funktionsweise eines DeltaSigma-Modulators; und

Fig. 9    Delta-Sigma-Modulator in geschalteter Kapazitätstechnik.

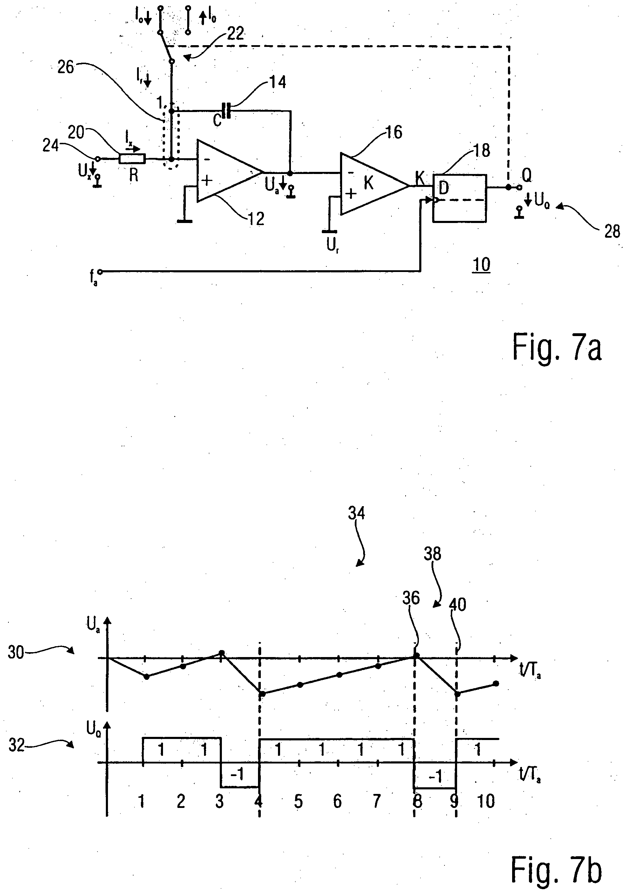

Da für die Analog/Digital-Wandlung von Messsignalen häufig Delta-Sigma-Modulatoren verwendet werden und deren Funktionsweise für das Verständnis des der Erfindung zugrundeliegenden Gedankens erforderlich ist, wird Anhand der Fig. 7a, 7b, 8 und 9 im Folgenden kurz die Funktionsweise typischer Ausführungsformen von Delta-Sigma-Modulatoren erläutert.

Fig. 7a und 7b zeigen dabei einen Delta-Sigma-Modulator, der an seinem Ausgang ein getaktetes digitales Signal zur Verfügung stellt, das auf kontinuierlichen Eingangsgrößen beruht. Der in Fig. 7a gezeigte Delta-Sigma-Modulator bzw. Delta-Sigma-Umsetzer 10 weist dabei einen Operationsverstärker 12 mit einer Kapazität 14 im Rückkopplungszweig, einen Komparator 16, ein mit der Abtastfrequenz $f_a$ getaktetes D-Flip-Flop 18, einen Eingangswiderstand 20 sowie einen Schalter 22 auf.

Der Eingangswiderstand 20 ist zwischen die zu digitalisierende Spannung 24 ($U_x$) und einen Schaltungs-

knoten 26 geschalten. Der Schaltungsknoten 26 ist mit dem invertierenden Eingang des Operationsverstärkers verbunden, so dass die Kapazität 14 im Rückkopplungszweig des Operationsverstärkers 12 zwischen den Ausgang des Operationsverstärkers 12 und den Schaltungsknoten 26 geschaltet ist. Der Schaltungsknoten 26 ist ferner mit einem Schalter 22 verbunden, der den Schaltungsknoten entweder mit einer Stromquelle verbindet, die einen positiven Balancestrom $I_r$ des Betrages $I_0$ liefert oder der den Schaltungsknoten 26 mit einer Stromquelle verbindet, die einen negativen Balancestrom $I_r$ des Betrages $I_0$ liefert. Der nicht invertierende Eingang des Operationsverstärkers 12 ist auf Masse geschalten, wobei der Ausgang des Operationsverstärkers 12 mit dem invertierenden Eingang des Komparators 16 verbunden ist, dessen nicht-invertierender Eingang auf einer Referenzspannung ($U_r$) liegt. Der Ausgang des Komparators 16 ist mit einem Eingang des getakteten D-Flip-Flops 18 verbunden, wobei der Ausgang des getakteten D-Flip-Flops 18 normierte Spannungspulse 28 zur Verfügung stellt, die einen digitalen Bitstrom bilden. Der Ausgang des D-Flip-Flops 18 ist darüber hinaus mit dem Schalter 22 verbunden, um den Schaltzustand des Schalters 22 zu steuern.

Anhand der Signalverläufe von Fig. 7b soll im Folgenden die Funktionsweise des Delta-Sigma-Modulators erläutert werden. Die zu digitalisierende Spannung 24 erzeugt über dem Eingangswiderstand 20 einen Strom $i_x$, der sich am Schaltungsknoten 26 mit dem Balancestrom $I_r$ addiert, so dass die Summe des Stroms $i_x$ + $I_r$ vom Kondensator 14 integriert wird. Der Balancestrom $I_r$ ist dabei betragsmäßig immer gleich $I_0$, jedoch kann die Stromflussrichtung mittels des Schalters 22 geändert werden. Im oberen Graphen 30 der Fig. 7b ist die Spannung $U_a$ am Ausgang des Operationsverstärkers als Funktion der Zeit in Einheiten der Taktzeit $T_a$, die zur Ansteuerung des D-Flip-Flops verwendet wird, dargestellt. Der untere Graph 32 zeigt die Spannung 28, die sich am Ausgang des D-Flip-Flops 18 einstellt, ebenfalls als Funktion der Zeit. Während einer ersten Phase 34, in der die Stromflussrichtungen von $i_x$ und $I_r$ einander entgegengesetzt sind, steigt die Spannung u.a. am Ausgang des Operationsverstärkers 12 langsam an, da der Netto in den Kondensator 14 fließende Strom IN kleiner als $i_x$ ist (IN = $i_x$ - $I_0$). Überschreitet die Spannung $U_a$ zum Zeitpunkt 36 die Referenzspannung des Komparators 16, so ändert sich die am Ausgang des Komparators 16 anliegende Spannung und der D-Flip-Flop 18 ändert seine Ausgangsspannung, die einen logischen Zustand 1 repräsentiert auf eine dazu inverse Ausgangsspannung (-1). Da nach Fig. 7a der Schalter 22 von der Ausgangsspannung 28 des D-Flip-Flops 18 gesteuert wird, ändert sich zum Zeitpunkt 36 auch die Stromflussrichtung des Stroms $I_r$, so dass von Zeitpunkt 36 an ein Nettostrom $I_N$ = $i_x$ + $I_0$ vom Kondensator 14 integriert wird, so dass sich die Spannung $U_a$ während einer Phase 38 schnell verringert. Im hier gezeigten Beispiel sinkt die Spannung am Kondensator 14 so schnell, dass bereits zum Zeitpunkt 40, also einen Takt nach Ändern der Stromflussrichtung, die Spannung $U_a$ am Eingang des Komparators 16 unter die Referenzspannung $U_r$ gesunken ist. Daher ändern der Komparator 16 und das D-Flip-Flop 18 zum Zeitpunkt 40 erneut sein Ausgangssignal (von -1 auf 1) und es beginnt eine erneute Zeitperiode mit kontinuierlich ansteigender Spannung $U_a$.

Die Geschwindigkeit, mit der die Spannung $U_a$ am Ausgang des Operationsverstärkers 12 abnimmt bzw. ansteigt, ist also von der Summe eines Vorzeichen behafteten Stroms $I_R$ und eines messgrößenabhängigen Stroms $i_x$ abhängig Daher ist auch die Anzahl von Takten der Lange $T_a$, die bei der jeweiligen Stromflussrichtung bis zum Erreichen der Schaltschwelle des Komparators 16 erforderlich ist, vom Strom $i_x$, also von der zu messenden Spannung $U_x$ abhängig. Der Verlauf der Spannung 28 am Ausgang des D-Flip-Flops 18, also die diese Spannung repräsentierende digitale Bitfolge beinhaltet somit die Information über die Größe des Messsignals 24, so dass mittels einer digitalen Signalverarbeitung am Ausgang des D-Flip-Flops 18 die Größe der zu messenden Spannung 24 leicht bestimmt werden kann.

Beim Delta-Sigma-Umsetzer der Fig. 7a wird also ein Prinzip der Ladungsbilanzumsetzung mittels eines mit festen Takt beschriebenen D-Flip-Flops implementiert. Dabei sind die analogen Eingangsgrößen kontinuierlich, sie werden dem Integrator also nicht getaktet zugeführt.

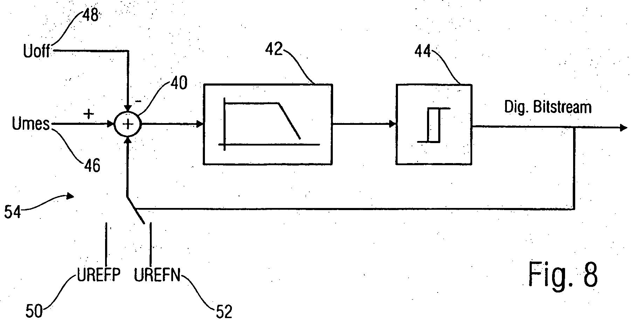

Fig. 8 zeigt erzeugt die prinzipielle Funktionsweise des Delta-Sigma-Modulationsverfahrens am Beispiel einer zu messenden Spannung, die zusätzlich mit einer Offset-Spannung zur Anpassung des dynamischen Bereichs beaufschlagt werden kann.

Dargestellt ist eine Addiereinrichtung 40, eine Integriereinrichtung 42 und eine Triggereinrichtung 44. Die Addiereinrichtung 40 ist mit der zu messenden Spannung 46, einer Offsetspannung 48 und wahlweise einer positiven Referenzspannung 50 oder einer negativen Referenzspannung 52 verbunden. Ein Schalter 54 steuert, ob die Addiereinrichtung 40 mit der positiven Referenzspannung 50 oder mit der negativen Referenzspannung 52 verbunden ist.

Die Triggereinrichtung 44 steuert das Schaltverhalten des Schalters 54, so dass das für das Verfahren der Delta-Sigma-Umsetzung wesentliche alternierende Addieren und Subtrahieren eines festen Referenzsignals zum Messsignal ermöglicht wird. Es ist zu bemerken, dass in Fig. 8 ferner die Möglichkeit geschaffen ist, eine Offset-Spannung 48 permanent zur Messspannung 46 zu addieren, wodurch beispielsweise ein nicht interessierender Gleichspannungsanteil von der zu messenden Spannung 46 subtrahiert werden kann.

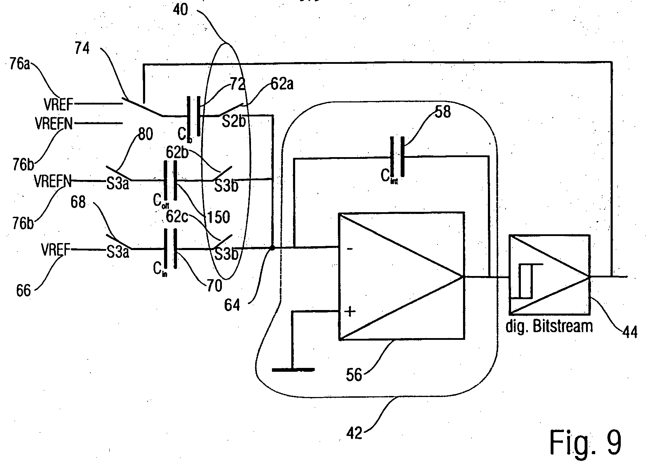

Fig. 9 zeigt eine Variation eines Delta-Sigma-Modulators, wobei in Fig. 9 eine Ausführungsform des in Fig. 8 gezeigten Prinzips dargestellt ist, sodass sich gleiche Funktionseinheiten identifizieren lassen, welche auch die gleichen Bezugzeichen erhalten. Fig. 9 zeigt eine Triggereinrichtung 44, eine Integriereinrichtung 42, die einen Operationsverstärker 56 sowie eine Rückkoppelkapazität 58 umfasst, sowie eine Addiereinrichtung 40, welche drei Schaltern 62a bis 62c aufweist.

Da die Funktionsweise der Triggereinrichtung 44 und der Integriereinrichtung 42 der Funktionsweise der anhand der Fig. 7a und 8 diskutierten Beispiele entspricht, wird auf diese im Folgenden nicht näher eingegangen werden, es sollen lediglich jene Aspekte diskutiert werden, die von den Fig. 7a, 7b und 8 abweichend sind.

In Fig. 9 werden die zu messenden Eingangsgrößen bzw. die notwendigen Balance- und Offsetgrößen nicht kontinuierlich sondern getaktet an den Eingang des Integrators angelegt und von einem externen Takt gesteuert. Ein Schaltungsknoten 64 ist mit dem invertierenden Eingang des Operationsverstärkers 56 leitend verbunden. Eine zu messende Eingangsspannung 66 ist über einen Schalter 68 mit einem ersten Anschluss einer Eingangskapazität 70 verbindbar, wobei ein zweiter Anschluss der Eingangskapazität 70 über den Schalter 62c mit dem Schaltungsknoten 64 verbunden werden kann.

Zum Ermöglichen des Ladungsbilanzprinzips ist ein erster Anschluss eines Balancekondensators 72 über einen Schalter 74 entweder mit einer positiven Referenzspannung 76a oder einer negativen Referenzspannung 76b verbindbar. Ein zweiter Ausgang des Balancekondensators 72 ist über den Schalter 62a mit dem Schaltungsknoten 64 verbindbar. Ein Öffset-Kondensator 78 kann mit einem ersten Anschluss über einen Schalter 80 mit der negativen Referenzspannung 76b verbunden werden, wobei ein zweiter Anschluss des Offsetkondensators 78 über den Schalter 62b mit dem Schaltüngsknoten 64 verbunden werden kann.

Das Prinzip der Ladungsbilanzumsetzung, wie es anhand der Fig. 7a und 8 bereits erläutet wurde, bleibt hierbei unverändert, jedoch wird die Ladung bzw. ein Strom der Integriereinrichtung 42 nicht mehr kontinuierlich zugeführt, sondern getaktet. Die Taktung wird durch synchrone Ansteuerung der Schalter 62a bis 62c und der Schalter 68, 74 und 80 erreicht. Zunächst wird durch Öffnen der Schalter 62a bis 62c und durch Schließen der Schalter 68, 74 und 80 eine Ladung auf die Kondensatoren 70, 72 und 78 aufgebracht. Dabei beschreibt die Ladung auf dem Eingangsköndensator 70 die zu messende Spannung 66 (da $Q \sim C$), die auf den Kondensator 78 aufgebrachte Offsetladung ermöglicht eine Subtraktion eines Offsets, und die auf den Balancekondensator 72 aufgebrachte Ladung ist die Balanceladung zur Umsetzung des Ladungsbilanzverfahrens. Die auf dem Balancekondensator 72 aufgebrachte Balanceladung hat immer dieselbe absolute Größe, jedoch unterschiedliches Vorzeichen, abhängig davon, ob der Balancekondensator 72 mit der positiven Referenzspannung 76a oder der negativen Referenzspannung 76b verbunden wird.

Im zweiten Schritt werden die Schalter 68, 74 und 80 geöffnet, sowie die Schalter 62a bis 62c geschlossen, so dass die auf den Kondensatoren 70, 72 und 78 akkumulierten Ladungen über den Schaltungsknoten 64 auf den Rückkoppelkondensator 58 übertragen werden, wobei das gleichzeitige Schließen der Schalter ein Addieren der Ladungen der Kondensatoren 70, 72 und 78 bewirkt.

Durch mehrmaliges Wiederholen obiger Schritte wird am Ausgang der Triggereinrichtung 44 ein Bitstrom erzeugt, dessen Bitmuster die Information über die Größe der zu messenden Eingangsspannung trägt. Dabei ist die Sämple-Frequenz, also die Frequenz, mit der die einzelnen Bits des Bitstroms erzeugt werden, abhängig von der festen Arbeitsfrequenz des Delta-Sigma-Modulators.

Die vorliegende Erfindung wird im Folgenden anhand von Beispielen diskutiert werden, die auf dem Prinzip der Analaog/Digital-Umsetzung mittels Delta-Sigma-Modulatoren beruhen, wobei die in den Figuren vorkommenden identischen Funktionalelemente mit denselben Bezugszeichen versehen sind. Dabei werden Figuren, die als Erweiterung bereits diskutierter Beispiele anzusehen sind, jeweils nur hinsichtlich der hinzugefügten neuen Aspekte diskutiert. Das Prinzip der Delta-Sigma-Modulatoren wurde anhand der Fig. 7a, 7b, 8 und 9 bereits erläutert, weswegen im Folgenden auf eine erneute Diskussion dieses Prinzips verzichtet wird.

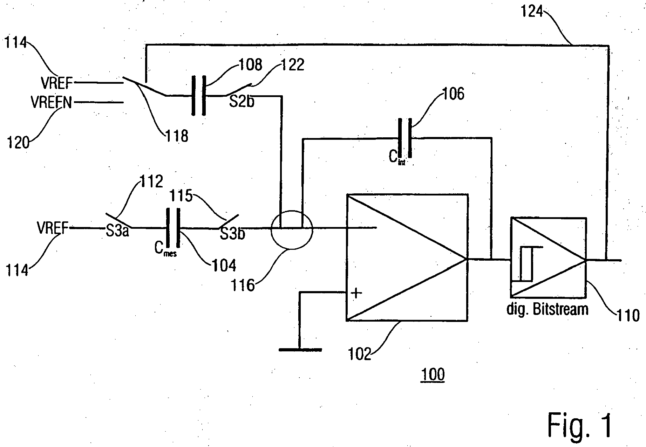

Fig. 1 zeigt eine beispielhalte Kapazitätsmesschaltung 100. Dargestellt ist ein Operationsverstärker 102, ein Messkondensator 104, ein Integrationskondensator 106, ein Balanceladungskondensator 108 sowie eine Triggereinrichtung 110. Der Operationsverstärker 102 und der Integrationskondensator 106 bilden zusammen einen Integrator, der die am invertierenden Eingang des Operationsverstärkers 102 anliegende Ladung bzw. den dort fließenden Strom auf der Integrationskapazität 106 integriert.

Ein erster Anschluss des Messkondensators 104 ist über einen Schalter 112 mit einer positiven Referenzspannung 114 verbindbar, ein zweiter Anschluss des Messkondensators 104 ist über einen Schalter 115 mit einem Schaltungsknoten 116 verbindbar, welcher leitend mit dem invertierenden Eingang des Operationsverstärkers 102 verbunden ist. Der nichtinvertierende Eingang des Operationsverstärkers 102 ist auf Masse geschalten und der Integrationskondensator 106 befindet sich im Rückkoppelzweig des Operationsverstärkers 102 und ist daher zwischen den Schaltungsknoten 116 und den Ausgang des Operationsverstärkers 102 geschalten. Der Ausgang des Operationsverstärkers 102 ist ferner mit einem Eingang der Triggereinrichtung 110 verbunden. Ein erster Anschluss des Balanceladungskondensators 108 kann über einen Schalter 118 mit der positiven Referenzspannung 114 oder einer negativen Referenzspannung 120 verbunden werden und ein zweiter Anschluss des Balanceladungskondensätors 108 kann über einen Schalter 122 mit dem Schaltungsknoten 116 verbunden werden. Die Schalterstellung des Schalters 118 wird von dem Ausgangssignal der Triggereinrichtung 110 gesteuert, weswegen diese über eine Steuerverbindung 124 mit dem Schalter 118 verbunden ist.

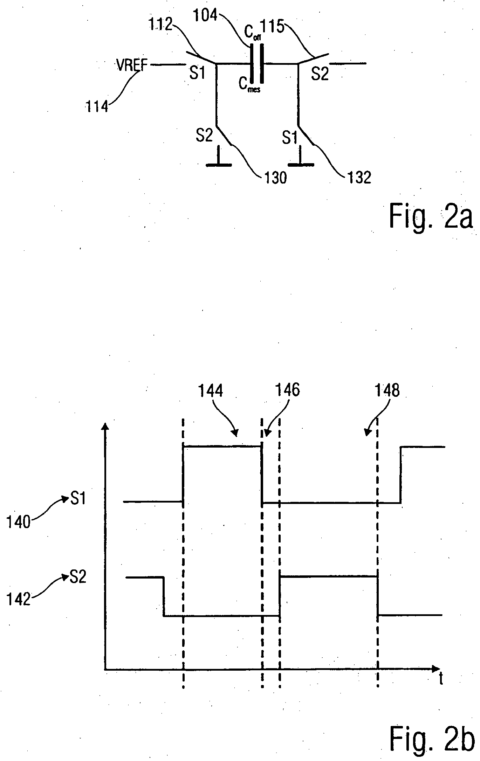

In dem in Fig. 1 gezeigten Beispiel ist die zu bestimmende Kapazität im Eingangszweig des Operationsverstärkers angeordnet, die variable, zu messende Kapazität ist also die Messkapazität 104. Das Delta-Sigma-Modulationsprinzip lässt sich durch getakteten Betrieb der Kapazitätsmessschaltung 100 erreichen, indem die Schalter 115 und 122 gemeinsam angesteuert werden und indem die Schalter 112 und 118 ebenfalls gemeinsam angesteuert werden, wobei die Ansteuerung mit einem nicht-überlappenden Zweiphasentakt konstanter Frequenz geschieht, wie es anhand der Fig. 2a und 2b im Folgenden erläutert wird.

Wie es anhand der Fig. 8 und 9 erläutert wurde, wird bei einem herkömmlichen Delta-Sigma-Modulator die Kapazität Cmes am Eingang des Modulators in der ersten Taktphase aus der zu messenden Eingangsspannung geladen. Die Ladung wird in der zweiten Taktphase auf die Integrationskapazität Cint gegeben und entsprechend dem bekannten Delta-Sigma-Prinzip weiterverarbeitet.

Beschrieben wird nun ein System, bei dem die Eingangsspannung Uin durch eine feste Referenzspannung ersetzt wird und die Kapazitäten im Eingangszweig oder durch Rückführung in der Messkapazitäten ersetzt werden.

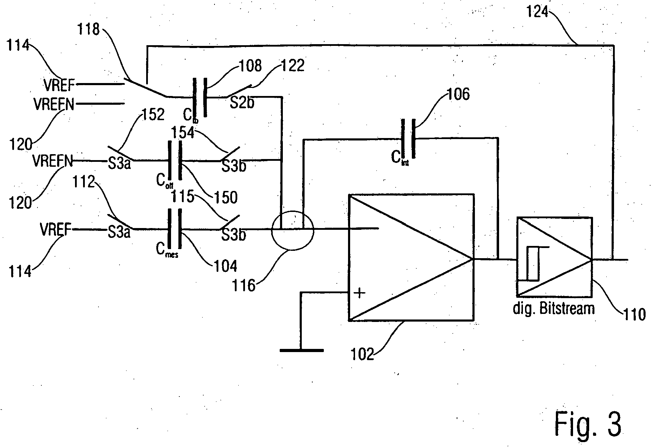

Die Messkapazität 104 wird dazu am Eingang eines Delta-Sigma-Modulators angekoppelt. Der Modulator arbeitet mit einer festen Arbeitsfrequenz. Die Messkapazität 104 (Cmes) wird über den Schalter 112 sukzessive aus einer definierten Spannung 114 (VREF) geladen. Die Ladung wird anschließend über den Schalter 115 auf die Integrationskapazität (106) des Integrators gegeben, integriert und ausgewertet. Die Schalter 112, 115, 122 und 118 werden mit einem nicht überlappenden 2-Phasentakt mit fester Frequenz betrieben. Der Ausgangsbitstrom, der von der Triggereinrichtung 110 ausgegeben wird, wird aufintegriert bzw. einem digitalen Filter zugeführt. Der Messbereich des Modulators wird dabei bestimmt durch das Verhältnis der Kapazitäten im Rückkopplungszweig (106) zum Eingangszweig (104). Wird ferner eine definierte Ladung von der Integrationsladung abgezogen, kann von der Messkapazität ein fester Offsetanteil abgezogen werden, wie es im Folgenden anhand von Fig. 3 noch erläutet werden wird.

Fig. 2a zeigt die Messkapazität 104 der Kapazitätsmessschaltung, die, wie es auch in Fig. 1 zu sehen ist, mit der positiven Referenzspannung 114 über den Schalter 112 verbindbar ist. In Fig. 2a ist ferner eine alternative Beschaltungsmethode der Messkapazität 104 mittels zweier Schalter 130 und 132 dargestellt, wobei die Messkapazität 104 mittels des Schalters 130 auf der Referenzspannungsseite gegen Masse geschlossen werden kann und wobei die Messkapazität 104 auf der Seite des Schaltungsknotens 116 mittels des Schalters 132 ebenfalls gegen Masse geschaltet werden kann. Es ist hierbei zu bemerken, dass hinsichtlich des erzielten Ergebnisses beide Schaltungsvarianten äquivalent sind, wenn sie mit einem Timing betrieben werden, dass in Fig. 2b dargestellt ist.

Fig. 2b zeigt einen nicht-überlappenden Zweiphasentakt konstanter Frequenz, der zum Betreiben der Kapazitätsmessschaltung bzw. zum Steuern der Schalter in Fig. 2a geeignet ist. Der Schalter 112 und der Schalter 132 werden mit dem ersten Taktsignal 140 (S1) angesteuert, wohingegen der Schalter 115 und der Schalter 130 mit dem zweiten Taktsignal 142 (S2) angesteuert werden. Wie es in Fig. 2b zu sehen ist, ist während einer Phase 144, in der Schalter 112 oder 132 geschlossen sind und der Kondensator mittels der Referenzspannung 114 geladen wird, die Schalter 115 und 130 geöffnet, so dass die Ladung nicht in Richtung des Operationsverstärkers abfließen kann.

In einer Phase 146 ist sowohl das Steuersignal 140 als auch das Steuersignal 142 low, das heißt, alle Schalter (112, 115, 130 und 132) sind geöffnet, so dass die Ladung auf der Messkapazität 104 verbleibt. In einer dritten Phase 148 schließlich ist Schalter 115 bzw. Schalter 130 geschlossen, so dass die Ladung, die sich auf der Messkapazität 104 befindet, in Richtung der Integrationskapazität abfließen kann.

Dabei ist zu beachten, dass es essentiell ist das die Ansteuerungssignale 140 und 142 nicht überlappen, um die vollständige auf dem Messkondensator 104 deponierte Ladung auf die Integrationskapazität übertragen zu können.

Fig. 3 zeigt ein Beispiel das eine Erweiterung des in Fig. 1 diskutierten Beispiels ist, bei dem zusätzlich die Möglichkeit vorgesehen ist, eine Offset-Kapazität bzw. ein Offset Signal von der zu messenden Kapazität zu subtrahieren.

Eine Offset-Kapazität 150 mit einem ersten Anschluss über einen Schalter 152 mit der negativen Referenzspannung 120 verbindbar. Die Offset-Kapazität 150 ist ferner mit einem zweiten Anschluss über einen Schalter 154 mit dem Schaltungsknoten 116 verbindbar. Die Ladung Qoff, die sich auf der Offset-Kapazität 150 befindet, wird zusammen mit den Ladungen Qmess auf der Messkapazität 104 und den Ladungen Ofb auf der Balancekapazität 108 getaktet auf den Integrationskondensator 106 transferiert. Dabei gilt für die pro Schritt übertragene Ladung Qint:

$$Qint = Qmess - (Qoff + Ofb)$$

Auf der Integrationskapazität 106 wird also gleichzeitig die Ladung der Messkapazität 104, der Offsetkapazität 150 und der Balanceladungskapazität 108 aufgebracht, wobei für die in der Fig. 3 gezeigte Beschaltung folgende Bedingungen erfüllt sein müssen, um das Ladungsbalanceprinzip zu ermöglichen:

$$Cfb > (Cmess - Coff)$$

$$Cmess > Cfb.$$

Die Schaltung arbeitet mit meinem nicht überlappenden Zweiphasentakt konstanter Frequenz. In der ersten Taktphase werden also die Schalter 112, 118 und 152 geschlossen und die Kapazitäten 104, 108 und 150 aufgeladen. In der zweiten Taktphase werden die Schalter 115, 122 und 154 geschlossen und die Ladungen aller drei Kapazitäten werden auf die Integrationskapazität 106 transferiert.

Mit dem in Fig. 3 gezeigten Beispiel kann ein statischer Anteil der zu messenden Kapazität 104 unterdrückt werden, wozu vorteilhafterweise die Größe der Offsetkapazität 150 so zu wählen ist, dass sie dem statischen Anteil der Messkapazität 104 entspricht.

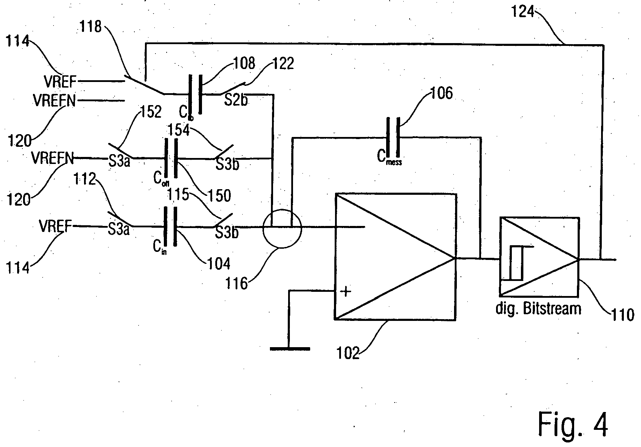

Fig. 4 zeigt eine alternative nicht erfindungsgemäße Ausführungsform der Kapazitätsmessschaltung von Fig. 3, die sich von Fig. 3 dadurch unterscheidet, dass die zu messende Kapazität die Kapazität 106 im Rückkoppelzweig des Operationsverstärkers 102 ist. Da die Funktionsweise ansonsten identisch mit der Anhand von Fig. 3 beschriebenen Funktionsweise ist, wird hinsichtlich einer detaillierten Beschreibung auf die Erläuterungen zu Fig. 3 verwiesen.

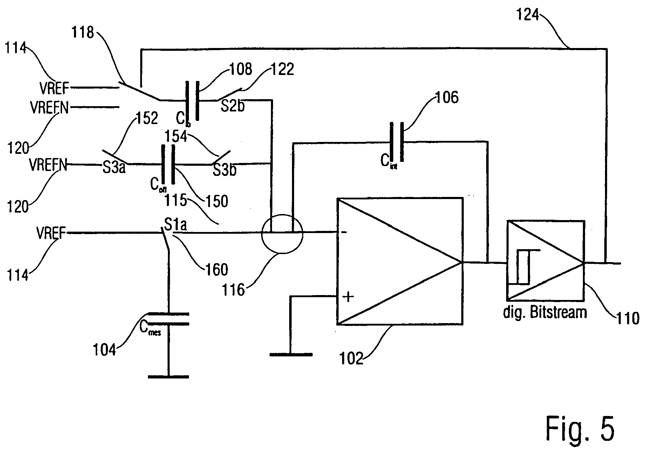

Fig. 5 zeigt ein weiteres Beispiel einer Kapazitätsmessschaltung, wobei die zu bestimmende Messkapazität 104 in einer alternativen Beschaltungsvariante im Eingangszweig des Operationsverstärkers 102 angeordnet ist. Die Messkapazität 104 ist mit einem ersten Anschluss auf Masse geschaltet, wobei sie mit einem zweiten Anschluss über einen Schalter 160 entweder mit der positiven Versorgungsspannung 114 oder mit dem Schaltungsknoten 116 verbunden werden kann. Die Ansteuerung erfolgt getaktet und äquivalent zu den vorhergehenden Beispielen, wobei der Schalter 160 derart gesteuert wird, dass dieser die Messkapazität mit der positiven Versorgungsspannung 114 zu Zeiten verbindet, in denen die Schalter 118 und 152 geschlossen sind. Der Schalter 160 verbindet die Messkapazität 104 mit dem Schaltungsknoten 116 zu den Zeiten, in denen die Schalter 122 und 154 geschlossen sind.

Bei ansonsten äquivalenter Funktionsweise ist es mit dem hier gezeigten Beispiel möglich, einen Schalter einzusparen, da der Schalter 160 als Wechselschalter betrieben wird.

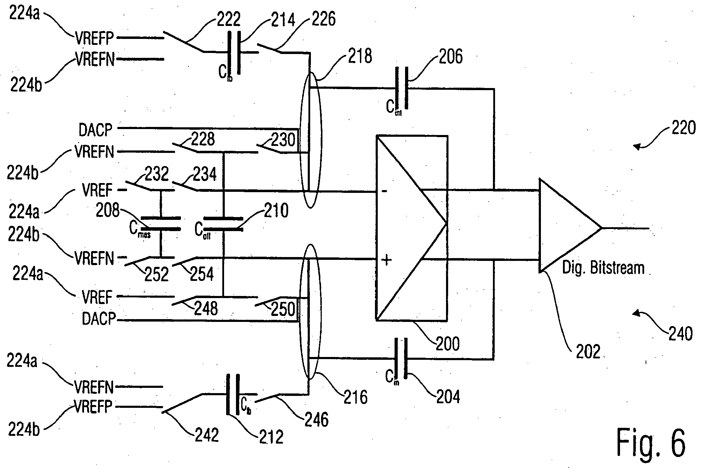

Fig. 6 zeigt eine erfindungsgemäße Kapazitätsmessschaltung, basierend auf einem Delta-Sigma-Modulator in differenzieller Struktur, die einen differenziellen Operationsverstärker 200, eine Signalverarbeitungseinrichtung 202, eine erste Integrationskapazität 204, eine zweite Integrationskapazität 206, eine Messkapazität 208, eine Offsetkapazität 210 sowie eine erste Balancekapazität 212 und eine zweite Balancekapazität 214 aufweist. Die erste Rückkoppelkapazität 204 ist zwischen den nicht-invertierenden Ausgang des differenziellen Operationsverstärkers und einen ersten Schaltungsknoten 216 geschalten und die zweite Rückkoppelkapazität 206 ist zwischen den invertierenden Ausgang des differenziellen Operationsverstärkers 200 und einem zweiten Schaltungsknoten 218 geschalten.

Der erste Schaltungsknoten 216 ist mit dem nicht-invertierenden Eingang des differenziellen Operationsverstärkers 200 verbunden und der zweite Schaltungsknoten 218 ist mit dem invertierenden Eingang des differenziellen Operationsverstärkers 200 verbunden. In einem invertierenden Zweig 220 der erfindungsgemäßen Kapazitätsmessschaltung in differenzieller Struktur ist ein erster Anschluss der zweiten Balancekapazität 214 über einen Schalter 222 entweder mit einer positiven Versorgungsspannung 224a oder einer negativen Versorgungsspannung 224b verbindbar. Ein zweiter Anschluss der zweiten Balancekapazität ist über einen Schalter 226 mit dem zweiten Schaltungsknoten 218 verbindbar. Ein erster Anschluss der Offsetkapazität 210 ist über einen Schalter 228 mit der negativen Referenzspannung 224b, sowie über einen Schalter 230 mit dem zweiten Spannungsknoten 218 verbindbar. Die Messkapazität 208 ist mit einem ersten Anschluss über einen Schalter 232 mit der positiven Versorgungsspannung 224a, sowie über einen Schalter 234 mit dem zweiten Schaltungsknoten 218 verbindbar.

In einem nicht-invertierenden Zweig 240 der erfindungsgemäßen Käpazitätsmessschaltung ist die erste Balancekapazität 212 über einen Schalter 242 entweder mit der negativen Referenzspannung 224b oder mit der positiven Referenzspannung 224a verbindbar. Ein zweiter Anschluss der ersten Balancekapazität 212 ist über einen Schalter 246 mit dem ersten Schältungsknoten 216 verbindbar. Ein zweiter Anschluss der Offsetkapazität 210 ist über einen Schalter 248 mit der positiven Referenzspannung 224, sowie über einen Schalter 250 mit dem ersten Schaltungsknoten 216 verbindbar. Die Messkapazität 208 ist mit einem zweiten Anschluss über einen Schalter 252 mit der negativen Referenzspannung 224b, sowie über einen Schalter 254 mit dem ersten Schaltungsknoten 216 verbindbar.

Wie es in Fig. 6 zu sehen ist, ist der differenzielle Operationsverstärker 200 also voll symmetrisch beschaltet, das heißt, bei ansonsten identischer Bauteilbestückung sind die positiven Referenzspannungsanschlüsse mit den negativen Referenzspannungsanschlüssen beim Übergang vom nicht-invertierenden Teil 240 zum invertierenden Teil 220 vertauscht. Die Ansteuerung der Kapazitätsmessschaltung in differenzieller Struktur, wie sie in Fig. 6 gezeigt ist, erfolgt äquivalent zu den nicht differenziellen Strukturen mit einem nicht überlappenden Zweiphasentakt, wie er beispielsweise in Fig. 2b gezeigt ist. Dabei werden die Schalter 222, 228, 232, 252, 248 und 242 von einem ersten Taktsignal (beispielsweise Signal 140 in Fig. 2b) gesteuert und die Schalter 226, 230, 234, 254, 250 und 246 werden von einem zweiten Taktsignal, das mit dem ersten Taktsignal nicht überlappt, (beispielsweise Taktsignal 142 in Fig. 2b) angesteuert.

Die Signalverarbeitungseinrichtung 202 addiert die integrierten Signale, die am invertierenden und am nicht-invertierenden Ausgang des differenziellen Operationsverstärkers 200 anliegen und erzeugt in Analogie zum nicht differenziellen Delta-Sigma-Modulator einen digitalen Bitstrom als Ausgangssignal, anhand dessen auch das Schaltverhalten der Schalter 222 und 242 gesteuert wird.

Der große Vorteil der hier gezeigten differenziellen Ausführungsform ist, dass Störungen, die der Schaltung durch beispielsweise induktive Effekte eingeprägt werden, durch die differenzielle Struktur weitestgehend kompensiert werden, so dass diese Messergebnis nicht verfälschen. Dies ist besonders in störreichen Umgebungen, wie z.B. Fahrzeugen von großem Vorteil.

Obwohl die erfindungsgemäße Kapazitätsmessschaltung im Vorhergehenden hauptsächlich in Verbindung mit der Messung von Kapazitäten zur Realisierung eines Einklemmschutzes für elektrische Fensterheber von Automobilen diskutiert wurde, ist die Kapazitätsmessschaltung selbstverständlich auch auf andere Bereiche anwendbar, in denen eine zuverlässige und schnelle Erfassung einer Kapazität wünschenswert ist.

Die erfindungsgemäße Kapazitätsmessschaltung erlaubt das Messen einer Kapazität, die in einem Zuleitungszweig des Operationsverstärkers angeordnet ist, wobei die Kapazitätsmessschaltung in differenzieller Form eine höhere Störsicherheit ermöglicht.

Obwohl in den Ausführungsbeispielen, die im Vorhergehenden diskutiert wurden, die erfindungsgemäße Kapazitätsmessschaltung mit lediglich zwei Referenzspannungen betrieben wird, ist es prinzipiell möglich, eine größere Anzahl von Referenzspannungen zu verwenden, wobei aus Gründen der Einfachheit der Implementierung eine Verwendung von lediglich zwei Referenzspannungen, die identischen Betrag aber unterschiedliches Vorzeigen haben, bevorzugt wird.

In der Kapazitätsmessschaltung in differenzieller Ausführung, wie sie in Fig. 6 gezeigt ist, sind die Kapazitäten 212 und 214 bzw. die Kapazitäten 204 und 206 jeweils paarweise gleich. Dies ist nicht zwingend erforderlich, für eine einfache Implementierung jedoch bevorzugt wird. Sind die angesprochenen Kapazitäten nicht paarweise gleich, so muss die Ungleichheit der Kapazitäten in der digitalen Signalverarbeitung berücksichtigt werden.

An die Größe der Kapazitäten, die in einer erfindungsgemäßen Kapazitätsmessschaltung zum Einsatz kommen, sind prinzipiell die bei der Erläuterung der Fig. 3 aufgestellten Forderungen zu stellen. Eine günstige Ausführungsform ist dabei beispielsweise diejenige, bei der die zu messende Kapazität in etwa doppelt so groß wie die Balancekapazität ist.

In den Beispielen, die eine Kapazitätsmessschaltung mit der Möglichkeit einer Offsetkorrektur zeigen, wird die Offsetkapazität in der Schaltung als diskretes Bauteil dargestellt. In einer realen Implementierung einer Schaltung kann die Offsetkapazität beispielsweise eine integrierte Siliziumkapazität, eine externe Offsetkapazität sein oder durch einen integrierten Kapazitäts-DAC-realisiert werden.

**Patentansprüche**

1. Getaktet betriebene Kapazitätsmessschaltung mit einer ersten Referenzsignalquelle (224a) und mit einer zweiten Referenzsignalquelle (224b), wobei die Kapazitätsmessschaltung einen Delta-Sigma-Modulator umfasst, der folgende Merkmale aufweist:

   einen Operationsverstärker (200) mit differenziellen Ausgängen,
   einen ersten Kondensator (208),
   einen zweiten Kondensator (204) in einem ersten Rückkopplungszweig zum nicht-invertierenden Eingang des Operationsverstärkers (200),
   einen dritten Kondensator (206) in einem zweiten Rückkopplungszweig zum invertierenden Eingang des Operationsverstärkers (200),
   Mittel (234, 254) zum Verbinden eines ersten Anschlusses des ersten Kondensators (208) mit dem invertierenden Eingang des Operationsverstärkers (200) und eines zweiten Anschlusses des ersten Kondensators (208) mit dem nicht invertierenden Eingang des Operationsverstärkers (200) in einem ersten Takt, und
   Mittel (232, 252) zum Verbinden des ersten Anschlusses des ersten Kondensators (208) mit der ersten Referenzsignalquelle (224a) und des zweiten Anschlusses des ersten Kondensators (208) mit der zweiten Referenzsignalquelle (224b) in einem, mit dem ersten Takt nicht-überlappenden zweiten Takt,

   wobei der erste Kondensator (208) eine zu messende Kapazität bildet.

2. Kapazitätsmessschaltung nach Anspruch 1, bei der die erste Referenzsignalquelle (224a) und die zweite Referenzsignalquelle (224b) ausgebildet sind, um betragsgleiche Referenzspannungen mit jeweils unterschiedlichem Vorzeichen bereitzustellen.

3. Kapazitätsmessschaltung nach einem der vorhergehenden Ansprüche, mit:

   einer Offsetsignalquelle; und
   Mitteln zum Verbinden der Offsetsignalquelle mit dem invertierenden Eingang des Operationsverstärkers (200) und mit dem nicht invertierenden Eingang des Operationsverstärkers (200), um dem zu messenden ersten Kondensator (208) eine konstante Offset-Kapazität aufzuschlagen.

**4.** Kapazitätsmessschaltung nach Anspruch 3, bei der die Offsetsignalquelle einen vierten Kondensator (210) aufweist, wobei die Kapazitätsmessschaltung zusätzlich folgendes umfasst:

Mittel zum Verbinden eines ersten Anschlusses des vierten Kondensators (210) mit dem invertierenden Eingang des Operationsverstärkers (200) und eines zweiten Anschlusses des vierten Kondensators (210) mit dem nicht-invertierenden Eingang des Operationsverstärkers (200); und
Mittel (228, 248) zum Verbinden des ersten Anschlusses des vierten Kondensators (210) mit der zweiten Referenzsignalquelle (224b) und des zweiten Anschlusses des vierten Kondensators (210) mit der ersten Referenzsignalquelle (224a).

**5.** Kapazitätsmessschaltung nach einem der vorhergehenden Ansprüche, mit:

einer ersten Balancesignalquelle;
einer zweiten Balancesignalquelle; und
Mitteln zum Verbinden der ersten Balancesignalquelle mit dem invertierenden Eingang des Operationsverstärkers (200) und der zweiten Balancesignalquelle mit dem nicht invertierenden Eingang des Operationsverstärkers (200) zum Bereitstellen eines positiven und eines negativen Balancesignals.

**6.** Kapazitätsmessschaltung nach Anspruch 5, bei der die erste und die zweite Balancesignalquelle je einen weiteren Kondensator (212, 214) aufweisen und die Kapazitätsmessschaltung zusätzlich folgendes umfasst:

Mittel (222, 242) zum Verbinden der weiteren Kondensatoren (212) mit der ersten Referenzsignalquelle (224a) oder mit der zweiten Referenzsignalquelle (224b).

**Claims**

**1.** Capacitance measuring circuit operated in a clocked manner comprising a first reference signal source (224a) and comprising a second reference signal source (224b), wherein the capacitance measuring circuit includes a delta-sigma modulator comprising:

an operational amplifier (200) comprising differential outputs,
a first capacitor (208),
a second capacitor (204) in a first feedback branch to the non-inverting input of the operational amplifier (200),

a third capacitor (206) in a second feedback branch to the inverting input of the operational amplifier (200),
means (234,254) for connecting a first terminal of the first capacitor (208) to the inverting input of the operational amplifier (200) and a second terminal of the first capacitor (208) to the non-inverting input of the operational amplifier (200) in a first clock, and
means (232,252) for connecting the first terminal of the first capacitor (208) to the first reference signal source (224a) and the second terminal of the first capacitor (208) to the second reference signal source (224b) in a second clock not overlapping the first clock,
wherein the first capacitator (208) forms a capacitance to be measured.

**2.** Capacitance measuring circuit according to claim 1, wherein the first reference signal source (224a) and the second reference signal source (224b) are configured to provide reference voltages comprising the same magnitude while each having a different sign.

**3.** Capacitance measuring circuit according to any one of the previous claims, comprising:

an offset signal source; and
means for connecting the offset signal source to the inverting input of the operational amplifier (200) and to the non-inverting input of the operational amplifier (200), to add a constant offset capacitance to the first capacitator (208) to be measured.

**4.** Capacitance measuring circuit according to claim 3, wherein the offset signal source comprises a fourth capacitor (210), the capacitance measuring circuit additionally comprising:

means for connecting a first terminal of the fourth capacitator (210) to the inverting input of the operational amplifier (200) and a second terminal of the fourth capacitator (210) to the non-inverting input of the operational amplifier (200); and
means (228,248) for connecting the first terminal of the fourth capacitor (210) to the second reference signal source (224b) and the second terminal of the fourth capacitor (210) to the first reference signal source (224a).

**5.** Capacitance measuring circuit according to any one of the previous claims, comprising:

a first balance signal source;
a second balance signal source; and
means for connecting the first balance signal source to the inverting input of the operational amplifier (200) and the second balance signal source to the non-inverting input of the operational amplifier (200), for providing a positive and a negative balance signal.

6. Capacitance measuring circuit according to claim 5, wherein the first and second balance signal sources each comprise another capacitor (212,214) and the capacitance measuring circuit additionally comprises:

> means (222,242) for connecting the other capacitors (212) to the first reference signal source (224a) or to the second reference signal source (224b).

**Revendications**

1. Circuit de mesure de capacité à fonctionnement cadencé avec une première source de signal de référence (224a) et avec une deuxième source de signal de référence (224b), le circuit de mesure de capacité comportant un modulateur delta-sigma qui présente les caractéristiques suivantes:

> un amplificateur opérationnel (200) avec des sorties différentielles,
> un premier condensateur (208),
> un deuxième condensateur (204) dans une première branche de couplage rétroactif à l'entrée sans inversion de l'amplificateur opérationnel (200),
> un troisième condensateur (206) dans une deuxième branche de couplage rétroactif à l'entrée à inversion de l'amplificateur opérationnel (200),
> des moyens (234, 254) destinés à connecter une première borne du premier condensateur (208) à l'entrée à inversion de l'amplificateur opérationnel (200) et une deuxième borne du premier condensateur (208) à l'entrée sans inversion de l'amplificateur opérationnel (200) à une première cadence, et
> des moyens (232, 252) destinés à connecter la première borne du premier condensateur (208) à la première source de signal de référence (224a) et la deuxième borne du premier condensateur (208) à la deuxième source de signal de référence (224b) à une deuxième cadence ne se recouvrant pas avec la première cadence, le premier condensateur (208) formant une capacité à mesurer.

2. Circuit de mesure de capacité selon la revendication 1, dans lequel la première source de signal de référence (224a) et la deuxième source de signal de référence (224b) sont réalisées pour mettre à disposition des tensions de référence de même grandeur, chacune avec un signe différent.

3. Circuit de mesure de capacité selon l'une des revendications précédentes, avec:

> une source de signal de décalage; et
> des moyens pour connecter la source de signal de décalage à l'entrée à inversion de l'amplificateur opérationnel (200) et à l'entrée sans inversion de l'amplificateur opérationnel (200), pour soumettre le premier condensateur à mesurer (208) à une capacité de décalage constante.

4. Circuit de mesure de capacité selon la revendication 3, dans lequel la source de signal de décalage présente un quatrième condensateur (210), le circuit de mesure de capacité comportant en outre:

> des moyens destinés à connecter une première borne du quatrième condensateur (210) à l'entrée à inversion de l'amplificateur opérationnel (200) et une deuxième borne du quatrième condensateur (210) à l'entrée sans inversion de l'amplificateur opérationnel (200); et
> des moyens (228, 248) destinés à connecter la première borne du quatrième condensateur (210) à la deuxième source de signal de référence (224b) et la deuxième borne de la quatrième capacité (210) à la première source de signal de référence (224a).

5. Circuit de mesure de capacité selon l'une des revendications précédentes, avec:

> une première source de signal d'équilibre;
> une deuxième source de signal d'équilibre; et
> des moyens destinés à connecter la première source de signal d'équilibre à l'entrée à inversion de l'amplificateur opérationnel (200) et la deuxième source de signal d'équilibre à l'entrée sans inversion de l'amplificateur opérationnel (200) pour mettre à disposition un signal d'équilibre positif et un signal d'équilibre négatif.

6. Circuit de mesure de capacité selon la revendication 5, dans lequel la première et la deuxième source de signal d'équilibre présentent, chacune, un autre condensateur (212, 214) et le circuit de mesure de capacité comporte en outre:

> des moyens (222, 242) destinés à connecter les autres condensateurs (212) à la première source de signal de référence (224a) ou à la deuxième source de signal de référence (224b).

Fig. 1

Fig. 2a

Fig. 2b

Fig. 3

Fig. 4

Fig. 5

Fig. 6

Fig. 7a

Fig. 7b

Fig. 8

Fig. 9

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6452521 B1
- US 6300776 B
- WO 03071230 A
- WO 2009090570 A